# EUROPEAN PATENT APPLICATION

(11) **EP 4 287 512 A1**
(43) Date of publication of application: **06.12.2023**
(21) Application number: 23176235.2
(22) Date of filing: 30.05.2023
(51) Int. Cl.: H03K 17/96, B29C 45/00, B60K 37/06, B60Q 3/64

(54) **SWITCH CONTROL BOARD FOR MOUNTING TO A VEHICLE INTERIOR PANEL, PRODUCTION METHOD**

(30) Priority: 30.05.2022 PT 2022118016
(71) Applicant: CENTITVC - Centro de Nanotecnologia e Materiais Tecnicos, Funcionais e Inteligentes, 4760-034 Vila Nova de Famalicão (PT); Simoldes Plásticos, SA, Oliveira de Azeméis, 3721-902 Santiago de Riba-UL (PT)
(72) Inventor: DA COSTA MESQUITA, RUI PEDRO, 4760-034 VILA NOVA DE FAMALICÃO (PT); RODRIGUES CAMPANHÃ, DANIELA CRISTINA, 4760-034 VILA NOVA DE FAMALICÃO (PT); PINTO DA SILVA, MARCO AURÉLIO, 4760-034 VILA NOVA DE FAMALICÃO (PT); FERREIRA DIAS, DUARTE NUNO, 4760-034 VILA NOVA DE FAMALICÃO (PT); FERNANDES DA SILVA, JOÃO MANUEL, 4760-034 VILA NOVA DE FAMALICÃO (PT); DA SILVA COELHO, JOSÉ AGOSTINHO, 3721-902 OLIVEIRA DE AZEMEIS (PT)
(74) Representative: Patentree

(57) **Abstract**

The present disclosure relates to a switch control board for mounting to a vehicle interior panel, preferably an interior door panel, comprising an injection-moulded part with diffuser polymer which comprises one or more foils comprising a capacitive sensor or sensors printed on a foil, and a decorative pattern printed on a foil, forming a layered product integrated in the injection-moulded part by insert moulding injection; and also, the method for obtaining said switch control board.

## Description

### TECHNICAL FIELD

The present disclosure relates to switch control board (cover switch) for mounting to a vehicle interior panel, preferably a door panel, produced by insert moulding and lamination processes with the integration of interactive surfaces and light effects, such as capacitive touch sensors, haptic feedback, and backlighting with LEDs. This fully integrated solution provides a modern, comfortable and appealing interface between the user and different functionalities controlled in this area (e.g., windows opening/closing, rear view mirrors adjustment).

### BACKGROUND

To receive inputs from an occupant, traditional automotive interiors may include numerous switches, buttons, dials, and other physical control devices. Control elements are coupled to corresponding features and systems include door locks, window regulator controls, seat and mirror position adjusters, headlights, steering wheel adjusters, among others.

US8994689B2 discloses the control of the windows in automotive vehicles where capacitive switches are used to actuate the up and down movement. Capacitive switch assembly for controlling power windows in automotive vehicles may be part of an armrest of a driver side front door. The capacitive switch assembly also includes a capacitive actuator including gesture response to an open and a close gesture made by a user with a finger on a gesture pad of the capacitive actuator. The gesture responsive capacitive sensors are located on the gesture pad so that the open and close gestures mimic the way in which a user moves an actuator of a mechanical switch to open and close a window. The capacitive switch assembly may include a button that enables and disables the power windows.

US11061475B2 discloses a vehicle interior component configured to provide a user interface comprising a composite structure. The composite structure may use a cover providing an exterior surface, and integrates a sensor, a display, a functional layer and a positioning layer. The cover may comprise a layer configured to facilitate the transmission of light. The sensor may be configured to detect input from the vehicle occupant at or adjacent to the exterior surface of the cover. The display may be configured to provide illumination at least partially visible through the exterior surface of the cover.

The documents EP3018562B1 and US20160132113A1 disclose haptic touch panel assemblies particularly in vehicle interiors. The haptic touch panel comprises a decorative side facing toward the interior of the vehicle, an opposite side facing toward the support substrate, and a user interface accessible at the decorative side of the panel that receives manual user input.

US20170362878 A1 discloses a vehicle door including a window and a regulator connected to the window. An electric motor is connected to the window regulator for moving the window between an open position and a closed position. A window control system is integral with the vehicle window. The window control zone includes a touch sensor that provides a control signal to a window ECU based on an operator touch.

The prior art describes several control panels and regulators inside automotive interiors to receive inputs from the occupants. Nonetheless, these panels present several shortcomings and do not provide an integrated function panel, being not functional neither user friendly.

These facts are disclosed in order to illustrate the technical problem addressed by the present disclosure.

### GENERAL DESCRIPTION

The present disclosure intends to surpass the limitations identified in the prior art, by developing a switch control board (cover switch) for mounting to a vehicle interior panel, preferably a door panel, produced, i.e., an integrated structure comprising a cover surface and configured to provide a user interface with sensor and actuator (e.g. an haptic feedback) for a vehicle interior component.

Within the scope of the present disclosure, cover switch is a switch control board, in particular an electric window switch control board or other relevant users' function for mounting to a vehicle interior panel; namely a vehicle interior door panel.

In an embodiment, the present disclosure relates to the development of a cover switch, comprising intelligent components, with the integration of interactive and decorative surfaces and light effects, such as capacitive touch sensors, haptic feedback, decorative cover and backlighting with LEDs.

In a preferred embodiment, the present disclosure is related to the development of a cover switch for mounting to a vehicle interior door panel comprising an injection-moulded part, comprising printed capacitive sensors and decorative foils integrated by insert moulding, and haptic feedback printed devices laminated on this part with LED backlighting. The smart injected part is incorporated into the door panel integrating smart functionalities (touch detection, and haptic feedback).

In an embodiment, the capacitive touch sensors and decorative foils are screen printed and integrated into the cover switch by insertion moulding. Each sensor is used to recognize the touch of the user, allowing the activation of functions such as opening/closing windows, adjusting mirrors, or other important functions for the user of the command control system of the present disclosure. In addition, this system comprises a decorative foil for protection and also has a decorative effect, through a printed pattern. In a preferred embodiment, said printed pattern is transparent or translucent to allows light to pass over strategic icons. The main effect is a total black appearance when the vehicle is switched off, whereas illuminated icons are shown when the vehicle is in operation.

An aspect of the present disclosure relates to a switch control board for mounting to a vehicle interior panel, preferably a door panel, comprising an injection-moulded part with diffuser foil which comprises one or more foils comprising a capacitive sensor or sensors printed on a foil and a decorative pattern printed on a foil, forming a layered product integrated in the injection-moulded part by insert moulding injection.

In an embodiment, the layered product comprises in sequence:
a decorative foil with a printed pattern;
injection-moulded part with diffuser polymer;
a sensor foil with printed capacitive sensor or sensors and a flat cable connecting said capacitive sensor or sensors.

In an embodiment, the layered product comprises in sequence:
injection-moulded part with diffuser polymer;
a decorative foil with a printed pattern;
a sensor foil with printed capacitive sensor or sensors and a flat cable connecting said capacitive sensor or sensors.

In an embodiment, the switch control board further comprises a haptic foil comprising a piezoelectric actuator.

In an embodiment, the haptic foil is attached to the injection-moulded part by lamination.

In an embodiment, the switch control board further comprises a printed circuit board, PCB, comprising an electric circuit, and light emitter or emitters for backlighting through the injection-moulded part with diffuser polymer.

In an embodiment, the switch control board is an electric window switch control board.

In an embodiment, the panel is a door panel.

In an embodiment, the sensor foil and a respective printed electric circuit flat cable extends beyond the layered product for providing external electric connections to the capacitive sensor or sensors.

In an embodiment, the sensor foil and printed electric circuit flat cable are electrically extended beyond the layered product by an electrically connected flat cable for providing external electric connections to the capacitive sensor or sensors.

In an embodiment, the flat cable comprises a printed electric circuit for providing external electric connections.

In an embodiment, the capacitive sensor or sensors are printed capacitive sensor or sensors using conductive ink.

In an embodiment, the foils are flexible.

In an embodiment, the decorative foil is fully or partially printed with a pattern of an opaque ink.

In an embodiment, the decorative foil is printed with a pattern of an opaque ink and translucent ink.

In an embodiment, the light emitter or emitters are aligned with a respective opening or openings in the printed pattern of the decorative foil for letting light pass through the decorative foil.

In an embodiment, the injection-moulded part comprise opening or openings for letting light through the decorative foil.

In an embodiment, the light emitter or emitters are aligned with a respective region or regions in the printed pattern of the decorative foil, said region or regions being printed with a translucent ink, for letting light through the decorative foil.

In an embodiment, the light emitter or emitters are aligned with a respective capacitive sensor of the sensor foil.

In an embodiment, the light emitter or emitters are aligned with a respective opening in the piezoelectric actuator for letting light through the haptic foil.

In an embodiment, the printed sensor, the printed decorative pattern, the printed piezoelectric actuator and/or the printed electric circuit are screen-printed.

In an embodiment, the said foil or foils are polymeric.

In an embodiment, the foil upon which the decorative pattern is printed, is a transparent or translucent foil.

In an embodiment, the foil upon which the capacitive sensor or sensors are printed, is a transparent or translucent foil.

In an embodiment, the light-emitter or emitters are LEDs.

In an embodiment, the piezoelectric actuator is a printed piezoelectric actuator.

In an embodiment, the printed circuit board, PCB, comprises an electronic circuit configured for activating the piezoelectric actuator when a touch is detected on a capacitive sensor or sensors.

In an embodiment, the printed circuit board, PCB, comprises an electronic circuit configured for activating a light emitter when a touch is detected on a capacitive sensor or sensors.

In an embodiment, the decorative foil has a thickness ranging from 100 µm to 350 µm; preferably 150 µm to 350 µm.

In an embodiment, the opaque ink layer has a thickness ranging from 20 µm to 80 µm, preferably from 30 µm to 40 µm.

In an embodiment, the translucid ink layer has a thickness ranging from 20 µm to 80 µm, preferably from 30 µm to 40 µm.

In an embodiment, the piezoelectric actuator comprises a multilayer sandwich.

In an embodiment, the multilayer sandwich comprises alternating films of piezoelectric flexible films and printed electrodes.

In an embodiment, the piezoelectric flexible films have a thickness ranging from 30 to 200 µm.

In an embodiment, the injection-moulded part is made of a polymeric material selected from a list consisting of: acrylonitrile butadiene styrene - ABS, nylon, high-density polyethylene - HDPE, polycarbonate - PC, polyoxymethylene - POM, polypropylene - PP, or mixtures thereof.

Another aspect of the present disclosure relates to a manufacturing process of a switch control board for mounting to a vehicle interior panel, preferably a door panel, comprising an injection-moulded part with a layered product integrated in the injection-moulded part by insert moulding injection; where the layered product comprises one or more foils comprising a capacitive sensor or sensors printed on a foil, an injection-moulded part with diffuser polymer a diffuser foil, and a decorative pattern printed on a foil.

In an embodiment, the manufacturing process further comprises providing a haptic foil comprising a piezoelectric actuator to the injection-moulded part.

In an embodiment, the haptic foil is attached to the injection-moulded part by lamination.

In an embodiment, the manufacturing process further comprises providing a printed circuit board, PCB, comprising an electric circuit, and light emitter or emitters for backlighting through the injection-moulded part with diffuser polymer.

### BRIEF DESCRIPTION OF THE DRAWINGS

The following figure provide preferred embodiments for illustrating the disclosure and should not be seen as limiting the scope of invention.

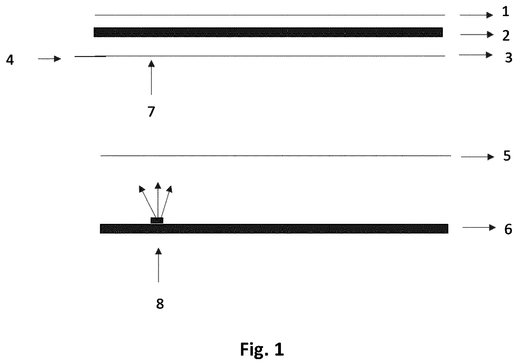

**Figure 1****:** Schematic representation of an embodiment of the layered product of the cover switch of the present disclosure. 1: decorative foil with a printed pattern; 2) injection-moulded part with diffuser polymer; 3) sensor foil with printed capacitive sensors; 4) Flat cable for electronic connections; 5) haptic foil comprising a piezoelectric actuator; 6) printed circuit board, PCB, comprising an electric circuit and light emitters; 7) and 8): alignment between all layers (decorative icons aligned with capacitive sensors aligned with lighting technology.

### DETAILED DESCRIPTION

The present disclosure relates to a switch control board for mounting to a vehicle interior panel, preferably a door panel, comprising an injection-moulded part with diffuser polymer, comprising intelligent functionalities, produced by insert moulding and lamination processes with the integration of interactive/decorative surfaces and light effects, such as capacitive touch sensors, haptic feedback, and backlighting with LEDs. This fully integrated solution can provide a modern, comfortable and appealing interface between the user and different functionalities controlled in this area (e.g., windows opening/closing, rear view mirrors adjustment).

The present disclosure relates to a switch control board for mounting to a vehicle interior panel, preferably a door panel, comprising an injection-moulded part with diffuser polymer which comprises one or more foils comprising a capacitive sensor or sensors printed on a foil, and a decorative pattern printed on a foil, forming a layered product integrated in the injection-moulded part by insert moulding injection; and also, the method for obtaining said switch control board.

In an embodiment, the present disclosure relates to a switch control board for mounting to a vehicle interior panel, preferably a door panel, comprising an injection-moulded part comprising an electric circuit, for lighting and sensing performances for the interior of a vehicle. This disclosure also relates to a process to obtain said switch control board.

In an embodiment, the haptic sensor provides a vibration feeling when a sensor is activated. This haptic feedback allows the user to assure the appropriate control of the different functionalities without need of a visual confirmation, representing a safer approach to the driver.

In an embodiment, the present disclosure relates to a switch control board, a multisensory interior's car component produced by a combination of printing techniques and injection / lamination integration processes. The switch control board of the present disclosure, is integrated in the car's door panel.

In an embodiment, the switch control board of the present disclosure is a multi-foil piece, integrating a decorative foil, an injected part with diffuser polymer, a sensor foil with printed capacitive sensors said capacitive sensors and a haptic foil.

The switch control board of the present disclosure is a touch command and is functional, ergonomic and has low weight, which are essential characteristics for its integration on vehicles interior. Additionally, the transparency or translucency of the touch command allow to integrate light devices for improved functionality and visual confort.

In an embodiment, the injection-moulded part is produced by injection processes, and different polymers can be used (e.g., polycarbonate). This production process will also integrate some of the cover switch's functionalities.

In an embodiment, one functionality incorporated is the touch sensors, responsible for the cover switch interactivity. These are capacitive sensors, changing its electric capacity with an interaction, produced by screen printing technology using a polymeric 90/140/180x31 mesh (90/140/180 yarns/cm and 31 µm yarn diameter).

In an embodiment, highly conductive inks (e.g., silver inks) with a sheet resistance between 10 and 25 mΩ/sq/mil and compatible with the insert moulding process are printed in a flexible substrate with thickness between 150 µm and 350 µm, compatible with both the printing and the insert moulding (e.g., PC flexible film). This printed process produces a printed foil with a thickness ranging from 20 µm to 80 µm. In an embodiment, the sensor foil has a specific design that allows passage of light at the centre of each sensor, matching the icons in the decorative foil. The design also contemplates a printed flat cable that extends to the controlling electronics where the detected touches control different functions of the car interior. This film is integrated into the cover switch piece by insert moulding, guaranteeing a fully integration.

In an embodiment, controlled functions can be adjusted in the cover switch of the present disclosure and can include windows opening/closing, door locking/unlocking, and rear-view mirrors adjustments.

In an embodiment, the decorative foil is produced by screen printing, using a polymeric 120/90x31/40 mesh (120/90 yarns/cm and 31/40 µm yarn diameter), and can be integrated in two approaches: printed in the same flexible substrate of the touch sensors and then incorporated into the cover switch by insert moulding or printed in a different substrate (also compatible with insert moulding and with a thickness ranging from 150 µm and 350 µm) and incorporated by insert moulding in the opposite side of the substrate with the printed touch sensors. The first approach allows a more integrated solution, reducing the number of components, and the second approach allows a better light diffusion and icon identification.

In an embodiment, different inks can be used to produce the decorative foil, but all must be compatible with the insert moulding process. An opaque and a translucid ink are used, the first one to define the icon mask and the second to uniformized the final aspect of the solution. Each printed layer has a thickness between 20 µm and 80 µm. This combination of inks allows passage of light only in the defined icons and the printing design must be aligned with the open areas in the touch sensor film, allowing passage of light in all icons.

In an embodiment, the piezoelectric actuator is composed of a multilayer sandwich, alternating a piezoelectric flexible film with thickness between 30 and 200 µm and printed electrodes, used to power the actuator. These electrodes are printed by screen printing with a polymeric 120/90x40 mesh (120/90 yarns/cm and 40 µm yarn diameter) with a conductive ink (e.g., silver ink) having a sheet resistance between 10 and 25 mΩ/sq/mil, directly in the piezoelectric film.

In an embodiment, the haptic foil (where electrodes are printed) used is transparent, allowing light passage and the printed electrodes' design avoids the icon areas to not block the backlighting. This actuator can have between 3 and 10 layers of piezoelectric film (in a sandwich configuration, the piezoelectric film between two printed electrodes) being coupled with the injected piece, below the touch sensors film by lamination processes. A single haptic feedback actuator is used, vibrating when the user interacts with any of the touch sensors. This feedback is generated by the controlling electronics used.

In an embodiment, the controlling electronics detect interactions between car users and the printed sensors, allowing the control of the different functionalities incorporated in this solution. These electronics are composed of a rigid printed circuit board (PCB) with all controlling components and LEDs integrated to light the defined icons. Different RGB LEDs can be used to allow a colour change and/or dimming light in a specific icon when it is touch by the user. These controlling electronics have a thickness between 1 mm and 5 mm and are laminated to the final solution, being placed below the haptic feedback actuator (haptic foil) and with the LEDs aligned with the icons defined in the decorative foil.

The switch control system of the present disclosure is a more integrated, lighter, more compact solution and provides additional functionalities, when compared with novel devices used. The incorporation of different components in the insert moulding process produces a more seamless and more aesthetics solution. The use of capacitive touch sensors, backlighting and haptic feedback creates a more interactive and modern solution.

With reference to the figure, some embodiments are now described in more detail, which are however not intended to limit the scope of the present application.

**Figure 1** shows a schematic representation of an embodiment of the cover switch for mounting to a vehicle interior door panel comprising an injection-moulded part of the present disclosure. The foils are properly aligned (decorative icons aligned with capacitive sensors aligned with lighting technology). The components of each foil and the respective specifications are depicted in Table 1.

**Table 1: Components of one embodiment of the cover switch of the present disclosure**

| Foil | Material(s) |
|---|---|
| **(1)** decorative foil with a printed pattern | - Foil PC |
| | - Ink: Decorative inks |
| | - Decorative pattern |
| **(2)** injection-moulded part with diffuser polymer | PC material |
| **(3)** sensor foil with printed capacitive sensors | - PC foil |
| | - Printed capacitive sensors |
| | - Printed electric circuit |
| | - Ink: conductive silver ink |
| **(4)** Flat cable for electronic connections | Printed electric circuit |
| **(5)** haptic foil comprising a piezoelectric actuator | - Commercial piezoelectric film |
| | - Isotropic adhesive |
| | - Piezoelectric actuator |
| | - Ink: conductive silver ink |
| **(6)** printed circuit board, PCB, comprising an electric circuit and light emitters | - Printed circuit board, PCB |
| | - Light emitters |

| | |
|---|---|
| N/A: not applicable | |

In an embodiment, the decorative foil comprises defined icons.

In an embodiment, the decorative foil is produced using opaque and translucid black inks.

In an embodiment, the decorative foil design allows passage of light in the defined icons.

In an embodiment, the decorative foil design covers all the command control system, uniformizing the final aspect of the solution, allowing only icons illumination.

In an embodiment, the decorative foil with different inks is integrated in the injection process of the production of the command control system.

In an embodiment, the haptic foil design allows passage of light in the defined icons in the decorative foil.

In an embodiment, the decorative foil may comprise different kind of inks.

In an embodiment, the substrate used to print the decorative foil allows light diffusion.

In an embodiment, the defined icons represent the associated functionality of the correspondent touch sensor, as windows opening/closing, rear view mirrors adjustment, among others.

In an embodiment, the decorative foil is printed on a flexible substrate compatible with injection processes (e.g., PC flexible film).

In an embodiment, the decorative foil with different inks is integrated in the injection process of the production of the command control system.

In an embodiment, the sensor foil is integrated in the injection process of the production of the multi-layered injection-moulded touch command of the present disclosure.

In an embodiment, the controlling electronics detect interactions between car users and the printed sensors.

In an embodiment, the printed circuit board have LEDs integrated to light the defined icons.

In an embodiment, the sensor interaction gives light feedback in LEDs correspondent to the touched sensor (e.g., colour change, dimming light).

In an embodiment, the printed circuit board comprises a printed piezoelectric actuator for haptic feedback.

In an embodiment, the sensor interaction activates the piezoelectric actuator, giving the user haptic feedback.

In an embodiment, the controlling electronics and piezoelectric actuator are laminated to the injection-moulded support.

In an embodiment, the cover switch of the present disclosure can be used in automotive doors, communicating with different door parts (e.g., mirrors, rear view mirrors, door handle).

In an embodiment, the cover switch of the present disclosure is connected to the car electronic control unit (ECU), allowing full control over assign car functions.

In an embodiment, with the ECU connection, different electronic functions/actions can be controlled by the cover switch of the present disclosure, being required to adjust the decorative foil design to fit the defined actions.

In an embodiment, the cover switch of the present disclosure allows a seamless and interactive solution to an important car piece.

The term "comprising" whenever used in this document is intended to indicate the presence of stated features, integers, steps, components, but not to preclude the presence or addition of one or more other features, integers, steps, components or groups thereof.

The disclosure should not be seen in any way restricted to the embodiments described and a person with ordinary skill in the art will foresee many possibilities to modifications thereof. The above described embodiments are combinable.

Where ranges are provided, the range limits are included. Furthermore, it should be understood that unless otherwise indicated or otherwise evident from the context and/or understanding of a technical expert, the values which are expressed as ranges may assume any specific value within the ranges indicated in different achievements of the invention, at one tenth of the lower limit of the interval, unless the context clearly indicates the contrary. It should also be understood that, unless otherwise indicated or otherwise evident from the context and/or understanding of a technical expert, values expressed as range may assume any sub-range within the given range, where the limits of the sub-range are expressed with the same degree of precision as the tenth of the unit of the lower limit of the range.

The following dependent claims further set out particular embodiments of the disclosure.

## Claims

1. Switch control board for mounting to a vehicle interior panel, preferably a door panel, comprising an injection-moulded part with diffuser foil which comprises one or more foils comprising a capacitive sensor or sensors printed on a foil and a decorative pattern printed on a foil, forming a layered product integrated in the injection-moulded part by insert moulding injection.

2. Switch control board according to the previous claim, wherein said layered product comprises in sequence:
the decorative foil with a printed pattern; preferably the decorative foil has a thickness ranging from 100 µm to 350 µm; preferably 150 µm to 350 µm;
the injection-moulded part with diffuser polymer;
the sensor foil with printed capacitive sensor or sensors and a flat cable connecting said capacitive sensor or sensors;
preferably said foils are flexible.

3. Switch control board according to the previous claim 1, wherein said layered product comprises in sequence:
the injection-moulded part with diffuser polymer;
the decorative foil with a printed pattern; preferably the decorative foil has a thickness ranging from 100 µm to 350 µm; preferably 150 µm to 350 µm;
the sensor foil with printed capacitive sensor or sensors and a flat cable connecting said capacitive sensor or sensors;
preferably said foils are flexible.

4. Switch control board according to any of the previous claims further comprising a haptic foil comprising a piezoelectric actuator; preferably the haptic foil is attached to the injection-moulded part by lamination.

5. Switch control board according to any of the previous claims further comprising a printed circuit board, PCB, comprising an electric circuit, and light emitter or emitters for backlighting through the injection-moulded part with diffuser polymer.

6. Switch control board according to any of the previous claims wherein the switch control board is an electric window switch control board.

7. Switch control board according to any of the previous claims wherein the sensor foil and a respective flat cable extends beyond the layered product for providing external electric connections to the capacitive sensor or sensors and/ or the sensor foil and flat cable are electrically extended beyond the layered product by an electrically connected flat cable for providing external electric connections to the capacitive sensor or sensors; preferably the flat cable comprises a printed electric circuit for providing external electric connections.

8. Switch control board according to any of the previous claims wherein the capacitive sensor or sensors are printed capacitive sensor or sensors using conductive ink.

9. Switch control board according to any of the previous claims wherein said decorative foil is printed with a pattern of an opaque ink and/or translucent ink; preferably the opaque ink layer and/or the translucent ink layer has a thickness ranging from 20 µm to 80 µm, preferably from 30 µm to 40 µm.

10. Switch control board according to any of the previous claims wherein said light emitter or emitters are aligned with a respective region or regions in the printed pattern of the decorative foil, said region or regions being printed with a translucent ink, for letting light through the decorative foil; and/or said light emitter or emitters are aligned with a respective capacitive sensor of the sensor foil and/or said light emitter or emitters are aligned with a respective opening in the piezoelectric actuator for letting light through the haptic foil, preferably the light emitter or emitters are LEDs.

11. Switch control board according to any of the previous claims wherein:
the printed sensor, the printed decorative pattern, the printed piezoelectric actuator and/or the printed electric circuit are screen-printed; preferably the foil upon which the decorative pattern is printed and/or the foil upon which the capacitive sensor or sensors are printed, is a transparent, translucent or semi-opaque foil.

12. Switch control board according to any of the previous claims wherein the printed circuit board comprises an electronic circuit configured for activating the piezoelectric actuator when a touch is detected on a capacitive sensor or sensors and/or configured for activating a light emitter when a touch is detected on a capacitive sensor or sensors.

13. Switch control board according to any of the previous claims wherein the piezoelectric actuator comprises a multilayer sandwich; preferably the multilayer sandwich comprises alternating films of piezoelectric flexible films and printed electrodes; preferably the piezoelectric flexible films have a thickness ranging from 30 to 200 µm.

14. Switch control board according to any of the previous claims wherein the injection-moulded part is made of a polymeric material selected from a list consisting of: acrylonitrile butadiene styrene, nylon, high-density polyethylene, polycarbonate, polyoxymethylene, polypropylene, or mixtures thereof.

15. Manufacturing process of a switch control board for mounting to a vehicle interior panel comprising an injection-moulded part with a layered product integrated in the injection-moulded part by insert moulding injection; where the layered product comprises one or more foils comprising a capacitive sensor or sensors printed on a foil, an injection-moulded part with diffuser polymer, and a decorative pattern printed on a foil.
